Europäisches Patentamt

European Patent Office

Office européen des brevets

(11) Veröffentlichungsnummer: **0 135 851**
**B1**

# EUROPÄISCHE PATENTSCHRIFT

(45) Veröffentlichungstag der Patentschrift:
29.11.89

(51) Int. Cl.⁴: **B 23 K 26/06, B 23 K 26/08**

(21) Anmeldenummer: 84110468.0

(22) Anmeldetag: 03.09.84

(54) Verfahren und Einrichtung zum Beschriften von Teilen, insbesondere von elektronischen Bauelementen.

(30) Priorität: 15.09.83 DE 3333386

(43) Veröffentlichungstag der Anmeldung:
03.04.85 Patentblatt 85/14

(45) Bekanntmachung des Hinweises auf die Patenterteilung:
29.11.89 Patentblatt 89/48

(84) Benannte Vertragsstaaten:
AT BE CH DE FR GB IT LI NL SE

(56) Entgegenhaltungen:
FR-A- 2 375 964
US-A- 3 256 524
US-A- 3 622 740
US-A- 3 902 036

ELECTRONIC DESIGN, Band 18, Nr. 18, September
1970, Seite 29, Hayden Publishing Co., Rochelle Park,
US; "Better circuit masks exposed"

(73) Patentinhaber: Siemens Aktiengesellschaft,
Wittelsbacherplatz 2, D-8000 München 2 (DE)

(72) Erfinder: Mattelin, Antoon, Dipl.-Ing., Leliestrasse 6,
B-8020 Oostkamp (BE)

**Beschreibung**

Die Erfindung betrifft ein Verfahren zum Beschriften von Teilen nach dem Oberbegriff des Anspruchs 1 und eine Einrichtung zum Beschriften von Teilen nach dem Oberbegriff des Anspruchs 2.

Ein derartiges Verfahren und eine derartige Einrichtung sind beispielsweise aus der DE-OS-3 147 355 bekannt. Dabei sind in den Strahlengang eines von einem Laser erzeugten Laserstrahles nacheinander ein Fotoverschluß, eine entsprechend der Beschriftungsaufgabe durch einen Prozeßrechner steuerbare Ablenkoptik und ein Objektiv angeordnet, welches den Laserstrahl auf die Oberfläche eines zu beschriftenden Teiles fokussiert. Das auf der Arbeitsfläche eines Arbeitstisches angeordnete Teil muß hierbei genau zum Bezugssystem des Lasers ausgerichtet werden, damit das Schriftfeld die vorgesehene Lage auf den zu beschriftenden Teilen einnimmt. Mit der Laser-Beschriftung können dann Teile aus Metall, Keramik, Halbleitermaterialien und einer Vielzahl von Kunststoffen entsprechend der Beschriftungsaufgabe mit Buchstaben, Ziffern, Markierungen, Firmensymbolen oder grafischen Darstellungen beschriftet werden. Dabei kann die Beschriftung in Gravierschrift, in Schmelzschrift oder in Verdampfungsschrift ausgeführt werden. Da die Oberfläche der zu beschriftenden Teile an der auftreffstelle des Laserstrahles dauerhaft verändert werden muß, ist die Geschwindigkeit, mit welcher die Beschriftung eines Teiles ausgeführt werden kann, begrenzt. Andererseits besteht insbesondere bei Teilen der Massenfertigung, wie z. B. bei elektronischen Bauelementen, das Bedürfnis, in möglichst kurzer Zeit möglichst viele Teile zu beschriften.

Der Erfindung liegt daher die Aufgabe zugrunde, bei einem Verfahren zum Beschriften von Teilen, insbesondere von elektronischen Bauelementen, die Schreibleistung deutlich zu erhöhen und eine für die erhöhte Schreibleistung geeignete Einrichtung zum Beschriften der Teile zu schaffen.

Diese Aufgabe wird bei einem gattungsgemäßen Verfahren durch die kennzeichnenden Merkmale des Anspruchs 1 und bei einer gattungsgemäßen Einrichtung durch die kennzeichnenden Merkmale des Anspruchs 2 gelöst.

Der Erfindung liegt die Erkenntnis zugrunde, daß bei der bekannten und technisch ausgereiften Laser-Beschriftung mit vertretbarem Aufwand allenfalls noch eine relativ geringe Erhöhung der Geschwindigkeit der Beschriftung erzielt werden kann. Eine wirtschaftliche und mit geringem Aufwand erreichbare Lösung des Problems ergibt sich jedoch durch eine Aufteilung des Laserstrahles in mindestens zwei Teilstrahlen, die mit unterschiedlichen Einfallswinkeln auf die Ablenkoptik gelenkt werden und dann die gleichzeitige Beschriftung von mindestens zwei Teilen ermöglichen. Bei einer Aufteilung des Laserstrahles in zwei Teilstrahlen und einer paarweisen Beschriftung der Teile wird also eine Verdoppelung der Schreibleistung erreicht. Hierzu braucht lediglich ein Strahlteiler zwischen dem Laser und der Ablenkoptik in den Strahlengang des Lasers eingefügt zu werden, wobei eine zusätzliche Umlenkeinrichtung die beiden Teilstrahlen mit unterschiedlichen Einfallswinkeln auf die Ablenkoptik lenkt.

Aus der FR-A-2 375 964 ist eine Einrichtung zur Bearbeitung von mit einer vorgegebenen Geschwindigkeit bewegten Teilen, insbesondere zum Schneiden und Schweißen von Plastikteilen, mittels eines Laserstrahls bekannt, bei welcher der Laserstrahl über einen drehbaren Polygonspiegel und nachgeordnete Umlenkspiegel in Form einer Brennlinie auf das zu bearbeitende Teil gelenkt wird. Durch in den Strahlengang zwischen dem Laser und dem Polygonspiegel eingefügte Strahlteiler kann das zu bearbeitende Teil auch gleichzeitig mit zwei oder mehreren, parallel zueinander ausgerichteten Brennlinien beaufschlagt werden. Hinweise auf die gleichzeitige Bearbeitung von zwei oder mehreren Teilen durch entsprechende Strahlaufteilung gehen aus dieser Druckschrift jedoch nicht hervor.

Der Strahlteiler kann ein teildurchlässiger Spiegel sein. Bei einer paarweisen Beschriftung der Teile wird als Strahlteiler vorzugsweise ein halbdurchlässiger Spiegel verwendet, welcher eine gleiche Leistung der beiden Teilstrahlen und damit eine gleichmäßige Beschriftung sämtlicher Teile gewährleistet.

Bei einer bevorzugten Ausgestaltung der Erfindung ist ein Teilstrahl in Richtung des Laserstrahles unmittelbar auf die Ablenkoptik lenkbar, während der andere Teilstrahl über die Umlenkeinrichtung auf die Ablenkoptik lenkbar ist. Für eine paarweise Beschriftung der Teile wird also lediglich eine einzige Umlenkeinrichtung benötigt.

Gemäß einer weiteren bevorzugten Ausgestaltung der Erfindung ist die Umlenkeinrichtung auf den Abstand der Schriftfelder von zwei auf der Arbeitsfläche angeordneten Teilen einstellbar. Auf diese Weise können die Teilstrahlen bei einem Loswechsel besonders leicht auf den geänderten Abstand zwischen den Schriftfeldern zweier zu beschriftender Teile eingestellt werden. Dabei wird als Umlenkeinrichtung vorzugsweise ein Umlenkspiegel verwendet. Wird als Umlenkeinrichtung ein drehbarer Umlenkspiegel verwendet, so kann die Einstellung auf den Abstand der Schriftfelder von zwei auf der Arbeitsfläche angeordneten Teilen durch eine Drehung des Umlenkspiegels und eine entsprechende Verstellung der Ablenkoptik vorgenommen werden. Die Umlenkeinrichtung kann jedoch auch als ein drehbarer und relativ zum Strahlteiler verschiebbarer Umlenkspiegel ausgebildet sein, wobei die Einstellung auf den Abstand der Schriftfelder von zwei auf der Arbeitsfläche angeordneten Teilen dann durch eine entsprechende Drehung und Verschiebung des Umlenkspiegels vorgenommen wird. Eine Verstellung bzw. Kompensation der Ablenkoptik kann dann entfallen.

Ein Ausführungsbeispiel der Erfindung ist in der Zeichnung dargestellt und wird im folgenden näher beschrieben.

Es zeigen

Fig. 1 eine Einrichtung zur gleichzeitigen Laser-Beschriftung von zwei Teilen in stark vereinfachter schematischer Darstellung und

Fig. 2 einen Teil der Ablenkoptik der in Fig. 1 dargestellten Einrichtung mit den unterschiedlichen Einfallswinkeln zweier Teilstrahlen.

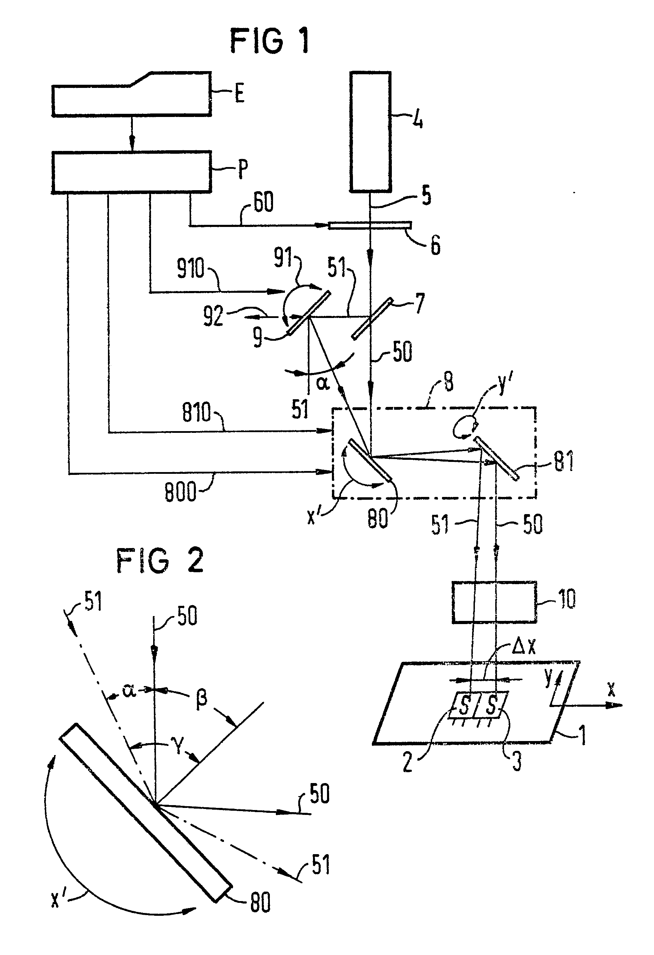

Fig. 1 zeigt eine Einrichtung zur gleichzeitigen Beschriftung von zwei auf einer Arbeitsfläche 1 angeordneten Teilen 2 und 3. Die Einrichtung umfaßt einen Laser 4, welcher einen Laserstrahl 5 erzeugt, in dessen Strahlengang aufeinanderfolgend ein Fotoverschluß 6 und ein Strahlteiler 7 angeordnet sind. Bei dem Strahlteiler 7 handelt es sich um einen halbdurchlässigen Spiegel, welcher einen Teil des Laserstrahles 5 hindurchläßt und den anderen Teil reflektiert. Der Strahlteiler 7 teilt also den Laserstrahl 5 in einen ersten Teilstrahl 50 und einen zweiten reflektierten Teilstrahl 51, wobei die Leistung der beiden Teilstrahlen 50 und 51 jeweils 50% der Leistung des Laserstrahles 5 beträgt. Der erste durch den Strahlteiler 7 hindurchgehende Teilstrahl 50 fällt unmittelbar auf den ersten drehbaren Ablenkspiegel 80 einer Ablenkoptik 8, während der zweite reflektierte Teilstrahl 51 mittelbar über eine Umlenkeinrichtung 9 auf den ersten Ablenkspiegel 80 gelenkt wird. Bei der Umlenkeinrichtung 9 handelt es sich um einen drehbaren und seitlich verschiebbaren Umlenkspiegel, dessen Verstellrichtungen durch Doppelpfeile 91 und 92 angedeutet sind. Durch Drehung und Verschiebung der Umlenkeinrichtung 9 kann der Winkel α, den der auf den ersten Ablenkspiegel 80 gelenkte zweite Teilstrahl 51 mit einer vertikalen Linie und damit auch mit dem ersten Teilstrahl 50 einschließt, eingestellt werden. Aus der Darstellung in Fig. 2 ist dabei zu ersehen, daß der Einfallswinkel des ersten Teilstrahles 50 mit β und der Einfallswinkel des zweiten, hier strichpunktiert dargestellten Teilstrahles 51 mit γ bezeichnet ist. Dabei gilt für den einstellbaren Winkel $\alpha = \gamma - \beta$.

Die Lage der beiden Teile 2 und 3 auf der Arbeitsfläche 1 ist in bezug auf ein ebenes kartesisches x-, y-Koordinatensystem festgelegt. Dementsprechend hat der erste drehbare Ablenkspiegel 80 der Ablenkoptik 8 die Aufgabe, die beiden Teilstrahlen 50 und 51 in der horizontalen Richtung x abzulenken, was in Fig. 1 durch einen Doppelpfeil x' angedeutet ist. Der zweite drehbare Ablenkspiegel 81 der Ablenkoptik 8 hat die Aufgabe, die beiden Teilstrahlen 50 und 51 in der vertikalen Richtung y abzulenken, was in Fig. 1 durch einen Doppelpfeil y' angedeutet ist. Nach dem Durchlaufen der Ablenkoptik 8 werden die beiden Teilstrahlen 50 und 51 dann durch ein Objektiv 10 auf die Oberfläche der zugeordneten Teile 3 bzw. 2 fokussiert, bei welchen es sich im dargestellten Fall um Kondensatoren mit einer Fläche von $1 \times 1\ cm^2$ handelt.

Der Abstand der Schriftfelder der auf der Arbeitsfläche 1 angeordneten Teile 2 und 3 ist mit Δx bezeichnet. Dieser Abstand Δx muß dann auch auf der Höhe der Oberfläche der Teile 2 und 3 zwischen den beiden Teilstrahlen 50 und 51 gewährleistet sein. Da der Abstand Δx sich aber mit der Geometrie der jeweils zu beschriftenden Teile ändern kann, muß er an die jeweiligen Bedingungen angepaßt werden können.

Diese Anpassung erfolgt über die bereits erwähnte Einstellbarkeit der Umlenkeinrichtung 9. Durch Verstellung dieser Umlenkeinrichtung 9 in Richtung der Doppelpfeile 91 und 92 kann der Winkel α zwischen den Teilstrahlen 50 und 51 auf den jeweils erforderlichen Abstand Δx eingestellt werden, wobei sich der Zusammenhang zwischen α und Δx ohne weiteres aus den Gesetzen der geometrischen Optik ableiten läßt.

Die Steuerung der Ablenkspiegel 80 und 81 der Ablenkoptik 8 entsprechend der jeweiligen Beschriftungsaufgabe erfolgt durch einen Prozeßrechner P, welchem eine Eingabe E zugeordnet ist. Die Leitungen für die Steuerung der Ablenkspiegel 80 und 81 sind dabei mit 8000 bzw. 810 bezeichnet. Der Prozeßrechner P steuert auch den Fotoverschluß 6, was durch eine entsprechende Leitung 60 dargestellt ist. Ferner ist es auch möglich, daß der Prozeßrechner P durch Steuerung der Umlenkeinrichtung 9 die Einstellung des Abstandes Δx übernimmt, wobei diese Möglichkeit durch eine entsprechende Leitung 910 aufgezeigt ist.

Mit der beschriebenen Einrichtung wird die paarweise Laser-Beschriftung von Teilen ermöglicht, was gegenüber herkömmlichen Einrichtungen eine Verdoppelung der Schreibleistung ergibt. Der Mehraufwand gegenüber den bisher verwendeten Einrichtungen ist dabei als äußerst gering anzusehen. In vielen Anwendungsfällen, wie z. B. bei der Beschriftung von lackierten Teilen oder Teilen aus Kunststoff, können die bisher verwendeten Laser beibehalten werden, da deren Leistung auch bei einer Strahlteilung für die Beschriftung noch ausreicht.

**Patentansprüche**

1. Verfahren zum Beschriften von Teilen, insbesondere von elektronischen Bauelementen, bei welchem ein Laserstrahl über eine entsprechend der Beschriftungsaufgabe gesteuerte Ablenkoptik auf die Oberfläche der auf einer Arbeitsfläche angeordneten Teile fokussiert wird, wobei die Ablenkoptik aus zwei nacheinander in den Strahlengang eingefügten und in verschiedenen Richtungen drehbaren Ablenkspiegeln besteht, dadurch gekennzeichnet, daß zum gleichzeitigen Beschriften von mindestens zwei auf der Arbeitsfläche (1) angeordneten Teilen (2, 3) der Laserstrahl (5) in mindestens zwei Teilstrahlen (50, 51) aufgeteilt wird, welche mit unterschiedlichen Einfallswinkeln (β, γ) auf die Ablenkoptik (8) gelenkt werden.

2. Einrichtung zum Beschriften von Teilen, insbesondere von elektronischen Bauelementen, mit einem Laser zur Erzeugung eines Laserstrahles, einer im Strahlengang des Laserstrahles angeordneten und entsprechend der Beschriftungsaufgabe steuerbaren Ablenkoptik und mit einem nach der Ablenkoptik angeordneten Objektiv, über welches der Laserstrahl auf die Oberfläche der auf einer Arbeitsfläche angeordneten Teile fokussierbar ist, wobei die Ablenkoptik aus zwei nacheinander in den Strahlengang eingefügten und in verschiedenen Richtungen drehbaren Ablenkspiegeln besteht, gekennzeichnet durch folgende Merkmale:

a) durch mindestens einen zwischen dem Laser (4) und der Ablenkoptik (8) angeordneten Strahlteiler (7) ist der Laserstrahl (5) in mindestens zwei Teilstrahlen (50, 51) teilbar,

b) die Teilstrahlen (50, 51) sind durch mindestens eine Umlenkeinrichtung (9) mit unterschiedlichen Einfallswinkeln (β, γ) derart auf die Ablenkoptik (8) lenkbar, daß mindestens zwei auf der Arbeitsfläche (1) angeordnete Teile (2, 3) gleichzeitig beschriftbar sind.

3. Einrichtung nach Anspruch 2, dadurch gekennzeichnet, daß der Strahlteiler (7) ein teildurchlässiger Spiegel ist.

4. Einrichtung nach Anspruch 3, dadurch gekennzeichnet, daß der Strahlteiler (7) ein halbdurchlässiger Spiegel ist.

5. Einrichtung nach einem der Ansprüche 2 bis 4, dadurch gekennzeichnet, daß ein Teilstrahl (50) in Richtung des Laserstrahles (5) unmittelbar auf die Ablenkoptik (8) lenkbar ist und daß der andere Teilstrahl (51) über die Umlenkeinrichtung (9) auf die Ablenkoptik (8) lenkbar ist.

6. Einrichtung nach einem der Ansprüche 2 bis 5, dadurch gekennzeichnet, daß die Umlenkrichtung (9) auf den Abstand (x) der Schriftfelder von zwei auf der Arbeitsfläche (1) angeordneten Teilen (2, 3) einstellbar ist.

7. Einrichtung nach Anspruch 6, dadurch gekennzeichnet, daß die Umlenkeinrichtung (9) ein Umlenkspiegel ist.

8. Einrichtung nach Anspruch 7, dadurch gekennzeichnet, daß die Umlenkeinrichtung (9) ein drehbarer Umlenkspiegel ist.

9. Einrichtung nach Anspruch 7, dadurch gekennzeichnet, daß die Umlenkeinrichtung (9) ein drehbarer und relativ zum Strahlteiler (7) verschiebbarer Umlenkspiegel ist.

## Claims

1. Process for marking parts, especially electronic components, in which a laser beam is focused onto the surface of the parts arranged on a work surface via a deflecting optical system controlled in accordance with the marking task, the deflecting optical system consisting of two deflecting mirrors inserted one after another in the beam path and rotatable in various directions, characterized in that for the purpose of simultaneous marking of at least two parts (2, 3) arranged on the work surface (1) the laser beam (5) is split into at least two component beams (50, 51), which are directed onto the deflecting optical system (8) at different incident angles (β, γ).

2. Device for marking parts, especially electronic components, comprising a laser for generating a laser beam, a deflecting optical system arranged in the beam path of the laser beam and controllable in accordance with the marking task, and an objective, arranged after the deflecting optical system, via which the laser beam can be focused onto the surface of the parts arranged on a work surface, the deflecting optical system consisting of two deflecting mirrors inserted one after another in the beam path and rotatable in various directions, characterized by the following features:

a) the laser beam (5) is divisible into at least two component beams (50, 51) by at least one beam splitter (7) arranged between the laser (4) and the deflecting optical system (8);

b) the component beams (50, 51) can be directed at different incident angles (β, γ) by at least one deflecting device (9) onto the deflecting optical system (8) in such a way that at least two parts (2, 3) arranged on the work surface (1) can be marked simultaneously.

3. Device according to Claim 2, characterized in that the beam splitter (7) is a partially transmitting mirror.

4. Device according to Claim 3, characterized in that the beam splitter (7) is a semi-transparent mirror.

5. Device according to one of Claims 2 to 4, characterized in that one component beam (50) in the direction of the laser beam (5) can be directed straight onto the deflecting optical system (8), and in that the other component beam (51) can be directed onto the deflecting optical system (8) via the deflecting device (9).

6. Device according to one of Claims 2 to 5, characterized in that the deflecting device (9) can be adjusted to the spacing (x) of the marking fields of two parts (2, 3) arranged on the work surface (1).

7. Device according to Claim 6, characterized in that the deflecting device (9) is a deviation mirror.

8. Device according to Claim 7, characterized in that the deflecting device (9) is a rotatable deviation mirror.

9. Device according to Claim 7, characterized in that the deflecting device (9) is a deviation mirror which is rotatable and displaceable relative to the beam splitter (7).

## Revendications

1. Procédé pour porter des inscriptions sur ou marquer des pièces, en particulier des composants électroniques, selon lequel on concentre un faisceau laser sur la surface des pièces, placées sur une surface de travail, au moyen d'une optique de balayage commandée conformément à l'inscription à réaliser, l'optique de balayage étant constituée de deux miroirs de balayage rotatifs disposés l'un après l'autre dans le trajet du faisceau et pouvant être tournés suivant des directions différentes, caractérisé en ce que, pour permettre le marquage simultané d'au moins deux pièces (2, 3) placées sur la surface de travail (1), on subdivise le faisceau laser (5) en au moins deux faisceaux partiels (50, 51) que l'on dirige sous différents angles d'incidence (β, γ) sur l'optique de balayage (8).

2. Dispositif pour porter des inscriptions sur ou marquer des pièces, en particulier des composants électroniques, comprenant un laser pour produire un faisceau laser, une optique de balayage disposée dans le trajet du faisceau laser et commandée conformément à l'inscription à réaliser, de même qu'un objectif placé à la suite de l'optique de balayage et au moyen duquel le faisceau laser est concentré sur la surface des pièces placées sur une surface de travail, l'optique de balayage étant constituée de deux miroirs de balayage insérés l'un à la suite de l'autre dans le trajet du faisceau et pouvant être tournés suivant des directions différentes, caractérisé en ce que:

a) le faisceau laser (5) est subdivisé en au moins deux faisceaux partiels (50, 51) par au moins un diviseur de faisceau (7) disposé entre le laser (4) et l'optique de balayage (8) et

b) les faisceaux partiels (50, 51) peuvent être dirigés sur l'optique de balayage (8) sous des angles d'incidence (β, γ) différents, par au moins un dispositif de déviation (9), de manière qu'au moins deux pièces (2, 3) placées sur la surface de travail (1) puissent être marquées simultanément.

3. Dispositif selon la revendication 2, caractérisé en ce que le diviseur de faisceau (7) est un miroir partiellement transparent.

4. Dispositif selon la revendication 3, caractérisé en ce que le diviseur de faisceau (7) est un miroir semi-transparent.

5. Dispositif selon une des revendications 2 à 4, caractérisé en ce qu'un faisceau partiel (50) peut être dirigé directement sur l'optique de balayage (8), suivant la direction du faisceau laser (5), et que l'autre faisceau laser partiel (51) peut être dirigé sur l'optique de balayage (8) par l'intermédiaire du dispositif de déviation (9).

6. Dispositif selon une des revendications 2 à 5, caractérisé en ce que le dispositif de déviation (9) peut être ajusté sur l'espacement (Δx) des zones d'écriture de deux pièces (2, 3) placées sur la surface de travail (1).

7. Dispositif selon la revendication 6, caractérisé en ce que le dispositif de déviation (9) est un miroir de déviation.

8. Dispositif selon la revendication 7, caractérisé en ce que le dispositif de déviation (9) est un miroir de déviation rotatif.

9. Dispositif selon la revendication 7, caractérisé en ce que le dispositif de déviation (9) est un miroir de déviation rotatif et déplaçable en translation par rapport au séparateur de faisceau (7).

# FIG 1

# FIG 2

7